# EUROPÄISCHE PATENTSCHRIFT

(11) **EP 2 174 339 B1**
(45) Veröffentlichungstag und Bekanntmachung des Hinweises auf die Patenterteilung: **26.01.2011**
(21) Anmeldenummer: 07856986.0
(22) Anmeldetag: 20.12.2007
(51) Int. Cl.: H01J 37/32

(54) **VERFAHREN ZUR ANSTEURUNG ZUMINDEST EINES INVERTERS IN EINER PLASMALEISTUNGSVERSORGUNGSEINRICHTUNG UND PLASMALEISTUNGSVERSORGUNGSEINRICHTUNG**
METHOD FOR OPERATING AT LEAST ONE INVERTER IN A PLASMA POWER SUPPLY DEVICE, AND A PLASMA POWER SUPPLY DEVICE
PROCÉDÉ D'AMORÇAGE D'AU MOINS UN INVERSEUR DANS UN DISPOSITIF D'ALIMENTATION EN PLASMA ET DISPOSITIF D'ALIMENTATION EN PLASMA

(30) Priorität: 23.07.2007 US 951392 P
(43) Veröffentlichungstag der Anmeldung: 14.04.2010
(73) Patentinhaber: HÜTTINGER Elektronik GmbH + Co. KG, 79111 Freiburg (DE)
(72) Erfinder: KIRCHMEIER, Thomas, 79331 Teningen (DE)
(74) Vertreter: Kohler Schmid Möbus
(86) Internationale Anmeldenummer: PCT/EP2007/011263
(87) Internationale Veröffentlichungsnummer: WO 2009/012803

(56) Entgegenhaltungen:
- EP-A- 1 783 904
- US-A1- 2004 031 566

## Beschreibung

Die Erfindung betrifft ein Verfahren zur Ansteuerung zumindest eines Inverters in einer Plasmaleistungsversorgungseinrichtung, der zumindest ein schaltendes Element aufweist. Die Erfindung betrifft weiter eine Plasmaleistungsversorgungseinrichtung zur Erzeugung einer Ausgangsleistung > 500 W bei einer im Wesentlichen konstanten Grundfrequenz > 3 MHz und zur Leistungsversorgung eines Plasmaprozesses, an welchen die erzeugte Ausgangsleistung geliefert und von welchem reflektierte Leistung zumindest bei Fehlanpassung an die Plasmaleistungsversorgungseinrichtung zurück geleitet wird, mit einer Messeinrichtung zur Messung einer mit der von dem Plasmaprozess reflektierten Leistung in Beziehung stehenden Größe und zum Vergleich der gemessenen Größe mit zumindest einem Referenzwert.

Bekannt geworden ist eine derartige Plasmaleistungsversorgungseinrichtung beispielsweise aus US 2007/0121267 A1, sowie aus EP 1 783 904 A1. Die von einer Hochfrequenz-(HF-)Quelle erzeugte Ausgangsleistung und die von der Last reflektierte Leistung werden durch jeweils einen Detektor einer Messeinrichtung erfasst. Die Messeinrichtung berechnet den Reflexionskoeffizienten aus der zur Last gelieferten und von dieser reflektierten Leistung und überwacht dessen zeitliche Änderung. Zwischen die HF-Quelle und die Last ist ein Impedanzanpassungsglied geschaltet, welches den Impedanzänderungen der Last folgt. Durch den Vergleich der zeitlichen Ableitung des Reflexionskoeffizienten mit einem Referenzwert wird eine Anomalie, d.h., eine zu schnelle Änderung des Reflexionskoeffizienten durch die Messeinrichtung erkannt. Um Beschädigungen am Impedanzanpassungsglied oder der HF-Quelle im Falle einer Anomalie zu vermeiden, wird bei einer zu schnellen Änderung des Reflexionskoeffizienten die HF-Quelle für eine bestimmte Zeit ausgeschaltet.

Eine Plasmaleistungsversorgungseinrichtung wird als Leistungsversorgungseinrichtung für Plasmaprozesse eingesetzt. Die Plasmaleistungsversorgungseinrichtung arbeitet bei einer Grundfrequenz, die nur geringfügig von einem Sollwert abweichen darf. Typische Grundfrequenzen sind 3,39 MHz, 13,56 MHz, 27,12 MHz, 40,68 MHz oder 62 MHz mit einer HF-Periode, die das Inverse der Grundfrequenz ist. Ein Inverter, der zumindest ein schaltendes Element aufweist, generiert aus dem Gleichspannungs-(DC-) Signal einer DC-Stromversorgung ein Wechselsignal, welches periodisch mit der Grundfrequenz sein Vorzeichen oder zumindest seine Stärke ändert. Dazu wird das zumindest eine schaltende Element im Takt der Grundfrequenz zwischen einem leitenden und einem nichtleitenden Zustand hin- und hergeschaltet. Das Ausgangsnetzwerk generiert aus dem durch den Inverter generierten Wechselsignal ein sinusförmiges HF-Ausgangssignal im Wesentlichen bei der vorgegebenen Grundfrequenz.

Bei einem Plasma handelt es sich um einen besonderen Aggregatszustand, der aus einem Gas erzeugt wird. Jedes Gas besteht grundsätzlich aus Atomen und/oder Molekülen. Bei einem Plasma ist dieses Gas zu einem Großteil ionisiert. Dies bedeutet, dass durch die Zufuhr von Energie die Atome bzw. Moleküle in positive und negative Ladungsträger, also in Ionen und Elektronen, aufgespalten werden. Ein Plasma eignet sich zur Bearbeitung von Werkstücken, da die elektrisch geladenen Teilchen chemisch hochgradig reaktiv und zudem durch elektrische Felder beeinflussbar sind. Die geladenen Teilchen können mittels eines elektrischen Feldes auf ein Werkstück beschleunigt werden, wo sie beim Aufprall einzelne Atome aus dem Werkstück herauslösen können. Die herausgelösten Atome können über Gasfluss abtransportiert werden (Ätzen) oder auf anderen Werkstücken als Beschichtung abgelagert werden (Herstellung von Dünnfilmen). Anwendung findet eine solche Bearbeitung mittels eines Plasmas vor allem dann, wenn extrem dünne Schichten, insbesondere im Bereich weniger Atomlagen, bearbeitet werden sollen. Typische Anwendungen sind Halbleitertechnik (Beschichten, Ätzen, etc.), Flachbildschirme (ähnlich Halbleitertechnik), Solarzellen (ähnlich Halbleitertechnik), Architekturglasbeschichtung (Wärmeschutz, Blendschutz, etc.), Speichermedien (CD, DVD, Festplatten), dekorative Schichten (farbige Gläser, etc.) und Werkzeughärtung. Diese Anwendungen haben hohe Anforderungen an Genauigkeit und Prozessstabilität. Weiterhin kann ein Plasma auch zur Anregung von Lasern, insbesondere Gaslasern dienen.

Um aus einem Gas ein Plasma zu generieren, muss ihm Energie zugeführt werden. Das kann auf unterschiedliche Weise, beispielsweise über Licht, Wärme oder elektrische Energie, erfolgen. Ein Plasma zur Bearbeitung von Werkstücken wird typischerweise in einer Plasmakammer gezündet und aufrechterhalten. Dazu wird in der Regel ein Edelgas, z.B. Argon, mit niedrigem Druck in die Plasmakammer geleitet. Über Elektroden und/oder Antennen wird das Gas einem elektrischen Feld ausgesetzt. Ein Plasma entsteht bzw. wird gezündet, wenn mehrere Bedingungen erfüllt sind. Zunächst muss eine geringe Anzahl von freien Ladungsträgern vorhanden sein, wobei zumeist die stets in sehr geringem Maß vorhandenen freien Elektronen genutzt werden. Die freien Ladungsträger werden durch das elektrische Feld so stark beschleunigt, dass sie beim Aufprall auf Atome oder Moleküle des Edelgases weitere Elektronen herauslösen, wodurch positiv geladene Ionen und weitere negativ geladene Elektronen entstehen. Die weiteren freien Ladungsträger werden wiederum beschleunigt und erzeugen beim Aufprall weitere Ionen und Elektronen. Es setzt ein Lawineneffekt ein. Der ständigen Erzeugung von Ionen und Elektronen wirkt die natürliche Rekombination entgegen, d.h. Elektronen werden von Ionen angezogen und rekombinieren zu elektrisch neutralen Atomen bzw. Molekülen. Deshalb muss einem gezündeten Plasma beständig Energie zugeführt werden, um dieses aufrecht zu erhalten.

Plasmaleistungsversorgungseinrichtungen müssen möglichst kleine Abmessungen besitzen, damit sie in der Anwendung nahe an den Plasmaentladungen angeordnet werden können. Sie sollen möglichst wiederholgenau und exakt arbeiten und möglichst geringe Verluste aufweisen, um einen hohen Wirkungsgrad zu realisieren. Eine weitere Anforderung sind möglichst geringe Herstellungskosten und hohe Wartungsfreundlichkeit. Nach Möglichkeit sollen Plasmaleistungsversorgungseinrichtungen ohne mechanisch angetriebene Bauteile auskommen, insbesondere sind Lüfter aufgrund ihrer begrenzten Lebensdauer und der Gefahr von Verschmutzungen unerwünscht. Weiter sollen Plasmaleistungsversorgungseinrichtungen gleichzeitig möglichst zuverlässig sein, sich nicht überhitzen und eine lange Betriebsdauer aufweisen.

Aufgrund der hohen Dynamik und den oftmals chaotischen Verhältnissen in Plasmaprozessen ist eine Plasmaleistungsversorgungseinrichtung viel höheren Anforderungen ausgesetzt als irgendeine andere Leistungsversorgungseinrichtung. Ein ungezündetes Gas, das nur eine sehr geringe Anzahl von freien Ladungsträgern besitzt, weist eine nahezu unendlich hohe Impedanz auf. Ein Plasma besitzt aufgrund seiner großen Anzahl freier Ladungsträger eine relativ niedrige Impedanz. Beim Zünden des Plasmas erfolgt also ein sehr schneller Impedanzwechsel. Ein gezündetes Plasma hat als weitere Eigenschaft, dass sich die Impedanz sehr schnell und oftmals unvorhersehbar ändern kann, man sagt die Impedanz ist dynamisch. Die Impedanz des Plasmas ist zudem auch noch im hohen Grad nichtlinear. Das bedeutet, dass eine Änderung der Spannung am Plasma nicht die analoge Änderung des Stroms hervorruft. Beispielsweise kann der Strom bei steigender Spannung sehr viel schneller ansteigen, hervorgerufen beispielsweise durch einen Lawineneffekt, oder der Strom kann auch bei so genannter negativer Impedanz mit steigender Spannung absinken.

Wenn eine Leistungsversorgungseinrichtung eine HF-Leistung in Richtung Last, wie einer Plasmalast, abgibt, die mit endlicher Geschwindigkeit zur Last fließt, dort aber nicht aufgenommen werden kann, weil sich bei der vorhandenen Spannung an der Last auf Grund der unterschiedlichen Impedanz nicht entsprechende gleichphasige Strom einstellt, so wird nur der Teil der HF-Leistung absorbiert, der sich aus Spannung und Strom in die Last berechnet, der restliche Anteil der HF-Leistung wird reflektiert. Dies erfolgt zwar auch bei Leistungsversorgungseinrichtungen mit niedrigen Frequenzen und auch bei Gleichstrom, nur bei diesen erfolgt das so schnell, dass sich die Spannung am Ausgang der Leistungsversorgungseinrichtung praktisch noch nicht verändert hat, wenn die reflektierte Energie zurückkommt. Es passiert für den Beobachter also zeitgleich. Bei Hochfrequenztechnik mit Frequenzen oberhalb ca. 1 MHz haben sich die Spannung und der Strom am Ausgang der Leistungsversorgung aber in der Regel schon verändert, wenn die reflektierte HF-Leistung zurückkommt.

In der Hochfrequenztechnik hat die reflektierte HF-Leistung einen beachtlichen Einfluss auf die Leistungsversorgungseinrichtungen. Sie kann Leistungsversorgungseinrichtungen destabilisieren und deren bestimmungsgemäßen Betrieb verhindern. Die reflektierte HF-Leistung auf Grund von Fehlanpassungen hat bei konstanten Impedanzen nur Anteile bei der Grundfrequenz. Diese lassen sich mit Filtern nicht blockieren und nicht absorbieren, weil Filter nicht zwischen vorwärts (zur Last) laufender Welle und rückwärts (von der Last) laufender Welle unterscheiden können und demzufolge auch die vorwärts laufende Welle blockieren oder absorbieren würden. Um die reflektierte HF-Leistung zu minimieren, werden sogenannte Impedanzanpassungsglieder bzw. -netzwerke eingesetzt, die sich in der Hochfrequenztechnik einfach durch Kombinationen von Induktivitäten, Kapazitäten und/oder Widerständen realisieren lassen. Wenn die Last aber keine konstante Impedanz ist, sondern eine dynamische und nichtlineare, so kommt es zu mindestens zwei zusätzlichen problematischen Phänomenen. Erstens werden von der nichtlinearen Impedanz Energien bei Frequenzen erzeugt, die ungleich der Grundfrequenz sind, und Teile dieser Frequenzen werden in Richtung der Leistungsversorgungseinrichtung geleitet. Diese werden mit Filtern blockiert bzw. absorbiert. Zweitens können die Impedanzanpassungsglieder den schnellen dynamischen Impedanzänderungen nicht schnell genug folgen, wodurch vermehrt Reflexionen bei der Grundfrequenz entstehen, die von der dynamischen Impedanz zu der Leistungsversorgungseinrichtung geleitet werden.

Anders als bei allen anderen Leistungsversorgungseinrichtungen müssen Plasmaleistungsversorgungseinrichtungen mit jedem beliebigen Fehlabschluss belastbar sein, den die oftmals chaotischen Verhältnisse in einem Plasmaprozess mit sich bringen können. Daher muss eine Plasmaleistungsversorgungseinrichtung in jedem Punkt des Smith-Diagramms zumindest kurzfristig HF-Leistung bereitstellen können und darf dabei keinen dauerhaften Schaden nehmen. Zusätzlich können auch noch in einem weiten Bereich Frequenzen ungleich der Grundfrequenz auftreten, die ebenfalls zu keinem dauerhaften Schaden der Plasmaleistungsversorgungseinrichtung führen dürfen. Eine bekannte Schutzmethode ist ein schnelles Abschalten der Plasmaleistungsversorgungseinrichtung bei Erkennen eines fehlerhaften Abschlusses.

Der Erfindung liegt die Aufgabe zugrunde, den genannten Anforderungen für eine Plasmaleistungsversorgungseinrichtung unter weitestgehender Vermeidung eines Eingriffes in die Schaltungsstruktur zu genügen.

Gelöst wird diese Aufgabe durch ein Verfahren zur Ansteuerung zumindest eines Inverters in einer Plasmaleistungsversorgungseinrichtung, der zumindest ein schaltendes Element aufweist, wobei der zumindest eine Inverter in einer ersten Betriebsart derart angesteuert wird, dass er eine erste Ausgangsleistung an eine an die Plasmaleistungsversorgungseinrichtung angeschlossene Last liefert, und in einer zweiten Betriebsart derart angesteuert wird, dass er keine oder eine geringere Ausgangsleistung an die angeschlossene Last liefert, wobei die von der Last reflektierte Leistung oder eine damit in Beziehung stehende Größe messtechnisch erfasst und mit zumindest einem Referenzwert verglichen wird und das Umschalten zwischen erster und zweiter Betriebsart in Abhängigkeit des zumindest einen Vergleichsergebnisses erfolgt, und/oder mit dem Beginn der Ansteuerung in einer Betriebsart eine Zeitmessung gestartet wird und das Umschalten in die andere Betriebsart nach Ablauf zumindest einer bestimmten Zeit erfolgt.

Die erste Betriebsart wird beispielsweise durch eine Ansteuerung des zumindest einen Inverters mit einem Tastverhältnis von nahe 50 %, die zweite Betriebsart durch eine Unterdrückung der Ansteuerung des zumindest einen Inverters, durch Verringerung der Spannung der DC-Stromversorgung und/oder durch eine Veränderung des Taktverhältnisses der Ansteuerung des zumindest einen Inverters erreicht.

In der ersten Betriebsart schickt der als HF-Quelle dienende zumindest eine Inverter eine vorzugsweise hohe vorwärtslaufende HF-Ausgangsleistung in Richtung Last. Trifft diese Ausgangsleistung auf eine nicht angepasste Last, so wird zumindest ein Teil dieser Leistung zum Inverter reflektiert. Wegen der Wellenlaufzeit kommt die reflektierte Leistung verzögert, d.h. mit einem Zeitversatz am Inverter an. Beim Eintreffen von insbesondere zu viel reflektierter Leistung, wird der zumindest eine Inverter in der zweiten Betriebsart betrieben, in dem er keine oder weniger HF-Ausgangsleistung abgibt. Die Wellenlaufzeit vom Inverter zur Last und zurück begrenzt hierbei die Pulslänge der reflektierten Leistung, da in der zweiten Betriebsart keine oder nur wenig vorwärts zur Last laufende Ausgangsleistung vom Inverter nachgeliefert wird.

Die zweite Betriebsart wird dann verwendet, wenn eine Messgröße der von der Last reflektierten HF-Leistung einen ersten Referenzwert erreicht, insbesondere überschreitet. Alternativ kann die zweite Betriebsart nach einer ersten bestimmten Zeit verwendet werden, in der die vom Plasmaprozess gegebenenfalls reflektierte HF-Leistung an der Plasmaleistungsversorgungseinrichtung zurückerwartet wird. Die bestimmte Zeit kann voreingestellt oder durch Beobachten der Messgröße für die reflektierte Leistung ermittelt werden. Analog dazu kann die erste Betriebsart wieder verwendet werden, wenn die Messgröße der von der Last reflektierten Leistung einen zweiten Referenzwert erreicht, insbesondere unterschreitet, oder wenn eine zweite bestimmte Zeit abgelaufen ist, wobei diese Zeit ebenfalls voreingestellt oder durch Beobachten der Messgröße für die reflektierte Leistung ermittelt werden kann. Der zweite Referenzwert kann gleich dem ersten Referenzwert sein. Da der führende Teil des Wellenzuges der hohen HF-Ausgangsleistung genauso schnell auf dem Weg von der Plasmaleistungsversorgungseinrichtung zum Plasmaprozess und als Reflexion von dort zurück ist wie dessen rückwärtiger Teil, der auf den Übergang von der ersten in die zweite Betriebsart folgt, ist es folgerichtig, die erste und zweite bestimmte Zeit gleichlang zu wählen.

Die Messgröße für die reflektierte Leistung kann von einem Richtkoppler stammen. Alternativ kann die reflektierte Leistung aus der Messung von Hochfrequenzstrom, Hochfrequenzspannung und/oder deren Phasenbeziehung bestimmt werden. Andere Messmethoden sind möglich.

Durch das zeitdiskrete Hin- und Herschalten des zumindest einen Inverters zwischen der ersten und der zweiten Betriebsart entsteht ein schneller Tastbetrieb mit einer als Zeitmittelwert definierten HF-Ausgangsleistung. Eine dauerhafte Begrenzung der Ausgangsleistung oder gar ein endgültiges Abschalten der Plasmaleistungsversorgungseinrichtung wird vermieden. Das Umschalten zwischen den Betriebsarten des zumindest einen Inverters erfolgt ereignis- und/oder zeitabhängig. Bei diesem Verfahren wird die Betriebssicherheit der Plasmaleistungsversorgungseinrichtung, insbesondere bei Lastfehlanpassung, erhöht und eine Leistungsversorgung mit einer dauerhaft hohen Ausgangsleistung sichergestellt. Zudem bleibt die Schaltungsstruktur der Plasmaleistungsversorgungseinrichtung nahezu unverändert. Dies ist insbesondere für Plasmaleistungsversorgungseinrichtungen wichtig, da dort ein Bereitstellen von Ausgangsleistung trotz Fehlanpassung erwünscht ist, um das Plasma nicht erlöschen zu lassen bzw. trotz Fehlanpassung zünden zu können. Zusätzliche Schutzschaltungen mit zusätzlichen Bauteilen, wie einer zusätzlichen Lastkomponente im Ausgangsfilter, können vermieden werden.

In der zweiten Betriebsart, insbesondere bei Erreichen des Referenzwertes, kann die von der Last reflektierte HF-Leistung in ein absorbierendes Bauteil abgeleitet werden. Die von der Last reflektierte HF-Leistung wird in dem absorbierenden Bauteil, welches typischerweise einen oder mehrere Widerstände aufweist, absorbiert. Alternativ kann die von der Last reflektierte HF-Leistung gleichgerichtet und in eine DC-Stromversorgung für den zumindest einen Inverter rückgeführt werden.

In einer Variante des Verfahrens kann die bestimmte Zeit in die Plasmaleistungsversorgungseinrichtung eingegeben werden. Bei dieser Variante kann die bestimmte Zeit vom Anwender fest vorgegeben werden. Die bestimmte Zeit kann abhängig von der Wellenlaufzeit vom Inverter zur Last und zurück eingestellt werden, mit anderen Worten, die bestimmte Zeit kann im Wesentlichen der Wellenlaufzeit vom Inverter zur Last und zurück entsprechen.

Die der Erfindung zugrunde liegende Aufgabe wird außerdem durch eine Plasmaleistungsversorgungseinrichtung der eingangs genannten Art gelöst, die zumindest einen Inverter mit zumindest einem schaltenden Element, eine Steuerung zur Ansteuerung des zumindest einen Inverters und einen Speicher zur Speicherung zumindest einer bestimmten Zeit aufweist, wobei die Steuerung in Abhängigkeit des von der Messeinrichtung ermittelten Vergleichsergebnisses und/oder der zumindest einen bestimmten Zeit den zumindest einen Inverter in einer ersten Betriebsart zur Lieferung einer ersten Ausgangsleistung oder in einer zweiten Betriebsart zur Lieferung einer geringeren oder keiner Ausgangsleistung ansteuert. Die Steuerung selbst kann der Speicher zur Speicherung der zumindest einen bestimmten Zeit sein bzw. einen solchen aufweisen. In Abhängigkeit von der Betriebsart können weitere Bauteile der Plasmaleistungsversorgungseinrichtung entsprechend geschaltet werden, beispielsweise kann ein Impedanzanpassungsglied ein- oder ausgeschaltet werden. Hierzu wird das von der Messeinrichtung generierte Signal zur Steuerung der Betriebsart den weiteren Bauteilen und/oder der Steuerung zugeführt.

In einer Ausführungsform der Plasmaleistungsversorgungseinrichtung ist das zumindest eine schaltende Element als MOSFET ausgebildet. Aufwendige Untersuchungen haben ergeben, dass ein Inverter mit mindestens einem schaltenden Element, insbesondere ein Klasse-D-Verstärker mit aus MOSFETs aufgebauten Halb- oder Vollbrücken, reflektierte Leistung verarbeiten kann, ohne Schaden zu nehmen, sofern die schaltenden Elemente für die Zeit, in der die reflektierte HF-Leistung anliegt, d.h. in der zweiten Betriebsart dauernd oder überwiegend ausgeschaltet sind. Mit "ausgeschaltet" ist der "bestimmungsgemäße nicht leitende Zustand" gemeint, mit anderen Worten der Zustand, in dem die Transistoren so angesteuert werden, dass diese nicht leiten. Hierbei werden die Transistoren in einen hochohmigen Zustand versetzt. Diese Definition trägt dem Umstand Rechnung, dass insbesondere MOSFETs immer eine Body-Diode aufweisen und auch im ausgeschalteten Zustand leitend sein können.

Das Umschalten des zumindest einen Inverters in die zweite Betriebsart sollte vorzugsweise erfolgen, bevor die von der Last reflektierte Leistung am Inverter eintrifft. Die am Inverter ankommende Leistung kann nur noch über die Body-Dioden in die DC-Stromversorgung, an welche der Inverter angeschlossen ist, fließen. Die MOSFETs verhalten sich ähnlich wie Kapazitäten, d.h. sie reflektieren ihrerseits die von der fehlangepassten Last reflektierte Leistung zum größten Teil, wobei die Body-Dioden eine Maximalspannungsbegrenzung bewirken. Bei der beim Betrieb der Plasmaleistungsversorgungseinrichtung verwendeten hohen Grundfrequenz speichern die Body-Dioden größtenteils die in Vorwärtsrichtung fließenden Ladungsträger und geben diese bei Stromrichtungsumkehr zu einem großen Teil wieder ab. Die am Inverter bzw. an den schaltenden Elementen erneut reflektierte Leistung wird typischerweise in ein absorbierendes Bauteil abgeleitet.

Der zumindest eine Inverter kann als Push-Pull-Stufe ausgebildet sein. Weiter kann der zumindest eine Inverter ein einziges schaltendes Element aufweisen. Der zumindest eine Inverter kann zumindest zwei schaltende Elemente in einer Halbbrückenanordnung oder zumindest vier schaltende Elemente in einer Vollbrückenanordnung aufweisen. Der zumindest eine Inverter kann ein Klasse-D-Verstärker oder ein Klasse-E-Verstärker sein. Die Plasmaleistungsversorgungseinrichtung weist in einer Ausführungsform mehrere, bevorzugt zwei Leistungsversorgungsmodule mit jeweils mindestens einem Inverter auf, die über zumindest einen Leistungskoppler zusammengekoppelt sind, wobei der zumindest eine Leistungskoppler die von den Leistungsversorgungsmodulen zur Last laufende Leistung phasenabhängig auf ein der Leistungsversorgung des Plasmaprozesses zugeordnetes erstes Tor oder ein zweites Tor leitet. In Abhängigkeit des Vergleichsergebnisses, insbesondere bei Erreichen eines ersten Referenzwertes, werden alle Inverter so angesteuert, dass sie keine oder nur eine geringe Ausgangsleistung abgeben.

Die Plasmaleistungsversorgungseinrichtung kann zumindest ein absorbierendes Bauteil aufweisen, welches von dem Plasmaprozess reflektierte Leistung, insbesondere bei der Grundfrequenz, zumindest teilweise absorbiert. Insbesondere ist das zumindest eine absorbierende Bauteil an das zweite Tor des zumindest einen Leistungskopplers angeschlossen. Das zumindest eine absorbierende Bauteil ist bevorzugterweise ein Absorptionswiderstand. Die Leistung, die am ersten Tor des Leistungskopplers ausgegeben wird, wird in Richtung Last oder zu weiteren Leistungskopplern geleitet. Die am zweiten Tor ausgegebene Leistung wird im absorbierenden Bauteil größtenteils absorbiert. Alternativ kann die Leistung am zweiten Tor gleichgerichtet und in die DC-Stromversorgung rückgeführt werden. Es ist jedoch auch denkbar, bei mehreren Leistungskopplern jedem zweiten Tor ein absorbierendes Bauteil zuzuordnen.

Der zumindest eine Leistungskoppler kann ein 90°-Hybrid sein, welcher für die von den Leistungsversorgungsmodulen kommenden Wellen als Leistungskoppler bzw. Combiner und für die von der Last zu den Leistungsversorgungsmodulen zurücklaufende Welle als Splitter dient. Damit sich die von den Leistungsversorgungsmodulen kommenden HF-Leistungen im 90°-Hybrid konstruktiv überlagern, müssen die Leistungsversorgungsmodule, insbesondere die Inverter der Leistungsversorgungsmodule, so angesteuert werden, dass sie um -n/2 versetzte Wellenzüge abgeben.

Die aufgrund von Fehlanpassung von der Last reflektierte HF-Leistung wird hälftig aufgeteilt und mit π/2-Phasenversatz an die Inverter der Leistungsversorgungsmodule gegeben. Das kapazitive Verhalten deren schaltender Elemente im ausgeschalteten Zustand bewirkt eine nahezu vollständige Reflexion der am Inverter ankommenden Welle, so dass diese HF-Leistung wiederum vorwärts in Richtung Leistungskoppler läuft. Aufgrund des abermaligen, gleichwirkenden π/2-Phasenversatzes im 90°-Hybrid haben die Wellenzüge nun eine im Vergleich zum Zustand der Erzeugung eine um π größere Phasenverschiebung, wodurch eine Vertauschung der Funktionen von erstem und zweitem Tor erfolgt, so dass die von den Invertern reflektierte Welle nicht zur Last, sondern über das zweite Tor zum absorbierenden Bauteil geleitet wird. Auf diese Weise entsteht ein "Time domain circulator", welcher in diskreten, durch die bestimmte Zeit definierten Schritten für die vorwärts laufende Ausgangsleistung und die rückwärts laufende reflektierte Leistung eine Weichenfunktion vergleichbar einem kontinuierlich arbeitenden klassischen Zirkulator erfüllt.

Weitere Vorteile und Merkmale der Erfindung ergeben sich aus der Beschreibung und den Figuren der Zeichnung. Ebenso können die vorstehend genannten und die noch weiter aufgeführten Merkmale erfindungsgemäß jeweils einzeln oder in beliebigen Kombinationen miteinander verwendet werden. Der Ablauf des erfindungsgemäßen Verfahrens ist in unterschiedlichen Varianten in den Figuren veranschaulicht. Weiter ist die erfindungsgemäße Plasmaleistungsversorgungseinrichtung in einem Ausführungsbeispiel in den Figuren gezeigt. Die in den Figuren gezeigten Merkmale sind rein schematisch und nicht maßstäblich zu verstehen.

Es zeigt:
- F**ig. 1a-1c**: jeweils ein Flussdiagramm von Verfahrensschritten zur Ansteuerung zumindest eines Inverters in einer Plasmaleistungsversorgungseinrichtung;
- **Fig. 2a-2c**: jeweils einen vereinfachten Schaltplan einer beispielhaften Plasmaleistungsversorgungseinrichtung zur Veranschau- lichung des Verfahrens aus Fig. 1a-1c; und
- **Fig. 3**: einen detaillierteren Schaltplan der Plasmaleistungs- versorgungseinrichtung aus den Fig. 2a-2c.

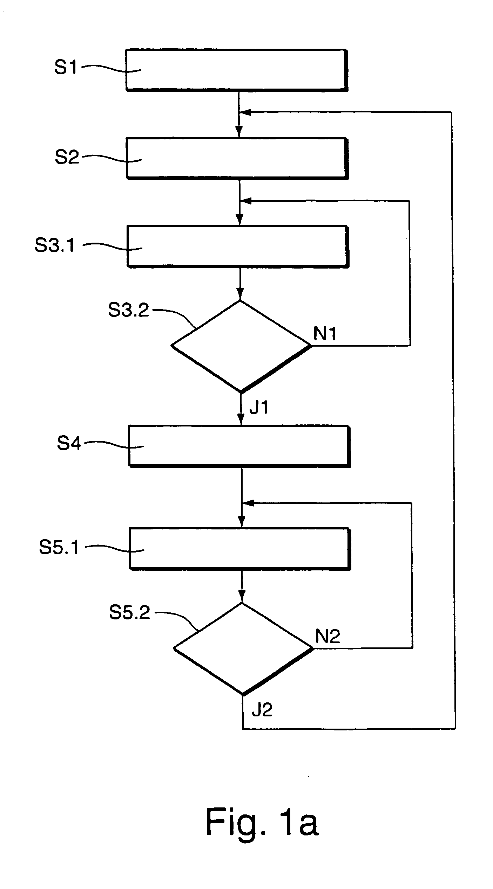

Das in den **Fig. 1a-1c** veranschaulichte Verfahren beginnt mit dem ersten Schritt S1, dem Einschalten einer Plasmaleistungsversorgungseinrichtung bzw. einer DC-Stromversorgung. Im zweiten Schritt S2 wird der zumindest eine Inverter in einer ersten Betriebsart so angesteuert, dass er eine erste, hier eine hohe HF-Ausgangsleistung erzeugt und an eine Last liefert.

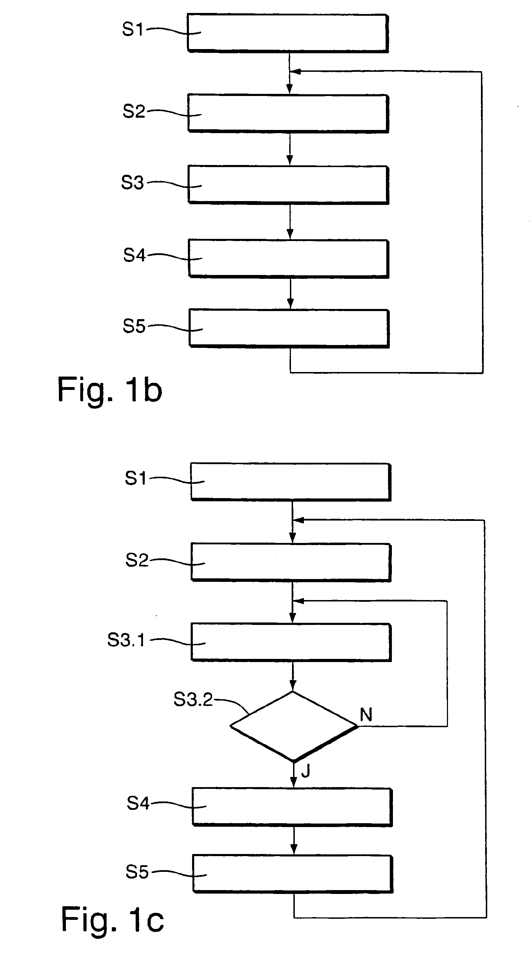

In den Verfahrensvarianten gemäß Fig. 1a und 1c wird in einem dritten Schritt S3.1 die von der Last reflektierte HF-Leistung oder eine damit in Beziehung stehende Größe messtechnisch erfasst und in einem ersten Zwischenschritt S3.2 wird der gemessene Wert mit einem ersten Referenzwert verglichen. Erreicht bzw. überschreitet der gemessene Wert den ersten Referenzwert (J1), so schließt sich ein vierter Schritt S4 an, in welchem der zumindest eine Inverter in einer zweiten Betriebsart so angesteuert wird, dass er keine oder eine geringere HF-Ausgangsleistung erzeugt. Andernfalls werden die Messung von Schritt S3.1 und der Vergleich von Schritt S3.2 wiederholt (N1). In der Verfahrensvariante nach Fig. 1b wird im dritten Schritt S3 eine erste bestimmte Zeit abgewartet. An den dritten Schritt S3 schließt sich unmittelbar der vierte Schritt S4, das Umschalten bzw. der Wechsel von der ersten in die zweite Betriebsart an.

Im fünften Schritt S5.1 wird in der Verfahrensvariante nach Fig. 1a abermals die von der Last reflektierte HF-Leistung oder eine damit in Beziehung stehende Größe gemessen und im zweiten Zwischenschritt S5.2 mit einem zweiten Referenzwert verglichen. Erreicht bzw. unterschreitet der gemessene Wert diesen zweiten Referenzwert (J2), kehrt das Verfahren zurück zum Schritt S2 und der zumindest eine Inverter wird wieder in der ersten Betriebsart angesteuert, ansonsten werden die Messung von Schritt S5.1 und der Vergleich von Schritt S5.2 wiederholt (N2). Bei den in den Fig. 1b und 1c veranschaulichten Verfahrensvarianten wird im fünften Schritt S5 vor der Rückkehr zum zweiten Schritt S2, der Ansteuerung des zumindest einen Inverters in der ersten Betriebsart, eine zweite bestimmte Zeit abgewartet.

Das Abwarten der ersten bestimmten Zeit (Schritt S3) ersetzt bei der Verfahrensvariante gemäß Fig. 1b die Messung und den Vergleich mit dem ersten Referenzwert (Schritte 3.1, 3.2) der Verfahrensvarianten aus Fig. 1a und 1c. Entsprechend ersetzt das Abwarten der zweiten bestimmten Zeit (Schritt S5) bei den Verfahrensvarianten gemäß Fig. 1b und 1c die Messung der reflektierten Leistung oder einer damit in Beziehung stehenden Größe während der zweiten Betriebsart und den Vergleich mit dem zweiten Referenzwert (Schritte 5.1, 5.2), wie in der Verfahrensvariante nach Fig. 1a ausgeführt.

Die bestimmten Zeiten stellen Wartezeiten dar und können unterschiedlich oder auch gleich gewählt werden. In Fig. 1c ist eine Mischung von messergebnis- und zeitgesteuerter Umschaltung, ein so genannter Mixmode, gezeigt, wobei auch eine Vertauschung von Messung und Zeitabwarten, d.h., das Abwarten einer ersten bestimmten Zeit während der ersten Betriebsart und eine Messung und ein Vergleich mit einem zweiten Referenzwert während der zweiten Betriebsart denkbar sind.

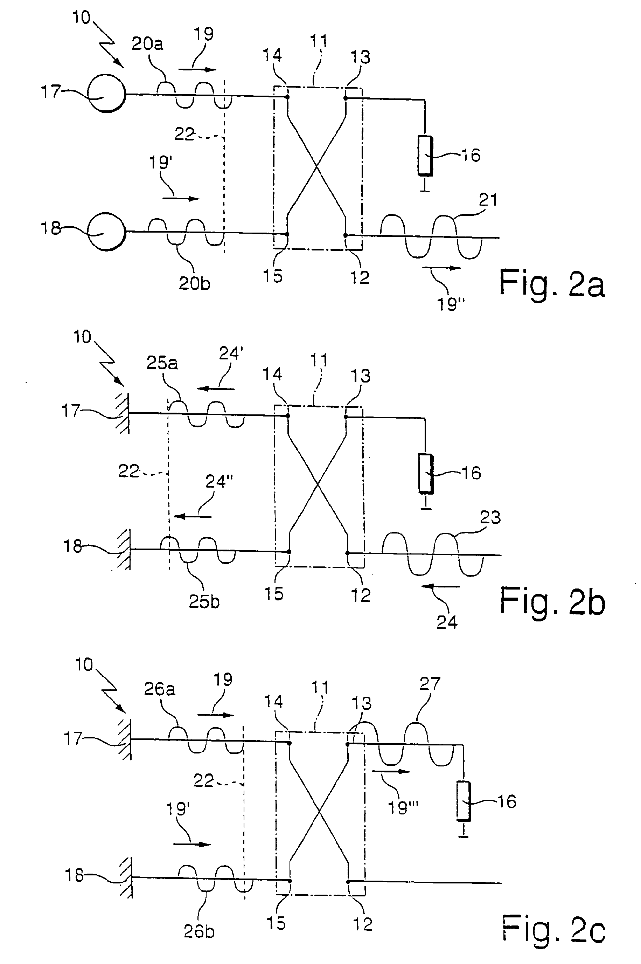

In den **Fig. 2a-2c** ist eine Plasmaleistungsversorgungseinrichtung 10 mit einem Leistungskoppler 11 gezeigt. Der Leistungskoppler 11 ist als 90°-Hybrid bzw. als 3-dB-Koppler ausgebildet und weist ein erstes Tor 12, ein zweites Tor 13, ein drittes Tor 14 und ein viertes Tor 15 auf. An das erste Tor 12 ist eine nicht gezeigte Last, insbesondere eine Plasmalast, angeschlossen. An das zweite Tor 13 ist ein als Absorptionswiderstand ausgebildetes absorbierendes Bauteil 16 angeschlossen. Das dritte Tor 14 und das vierte Tor 15 dienen als Eingänge für ein erstes Leistungsversorgungsmodul 17 und ein zweites Leistungsversorgungsmodul 18. Die Leistungsversorgungsmodule 17 und 18 weisen jeweils ein Ausgangsnetzwerk und zwei Inverter (in den Fig. 2a-2c nicht gezeigt) auf und erzeugen in Vorwärtsrichtung 19 bzw. 19' laufende Ausgangsleistung. Die Vorwärtsrichtung 19, 19' ist die Richtung von den Leistungsversorgungsmodulen 17, 18 bzw. deren Invertern zur zu versorgenden Last. Von den Leistungsversorgungsmodulen 17, 18 erzeugte Wellen 20a, 20b werden mittels des Leistungskopplers 11 zu einer zur Last laufenden Gesamtwelle 21 zusammengeführt. Aufgrund des mit einer Linie 22 angedeuteten Phasenversatzes zwischen den beiden erzeugten Wellen 20a und 20b (die Welle 20a eilt der Welle 20b voraus) wird die in Vorwärtsrichtung 19" laufende Gesamtwelle 21 am ersten Tor 12 des Leistungskopplers 11 ausgegeben und zur Last geführt.

Während in Fig. 2a die eine hohe Ausgangsleistung erzeugende erste Betriebsart der Plasmaleistungsversorgungseinrichtung 10 gezeigt ist, ist in Fig. 2b die zweite Betriebsart gezeigt, in welchem die Inverter der Leistungsversorgungsmodule 17, 18 keine oder sehr geringe Ausgangsleistung liefern. Diese Umschaltung erfolgte aufgrund einer messtechnischen Erfassung einer von der Last reflektierten Gesamtwelle 23 gemäß dem anhand von Fig. 1a oder 1c erläuterten Verfahren und/oder aufgrund einer bestimmten Zeit gemäß dem anhand von Fig. 1b oder 1c erläuterten Verfahren. Die in eine der Vorwärtsrichtung 19" entgegengesetzte Rückwärtsrichtung 24 laufende reflektierte Gesamtwelle 23 wird vom Leistungskoppler 11 in zwei zu den beiden Leistungsversorgungsmodulen 17, 18 laufende reflektierte Wellen 25a, 25b aufgeteilt. Bedingt durch das kapazitive Verhalten der Inverter sind die Inverter der Leistungsversorgungsmodule 17, 18 im ausgeschalteten Zustand, der in der zweiten Betriebsart dauernd oder überwiegend vorliegt, für die zurückkommende HF-Leistung stark fehlangepasst. Infolgedessen werden die in Rückwärtsrichtung 24', 24" laufenden reflektierten Wellen 25a, 25b dort nahezu vollständig reflektiert und laufen entsprechend der Darstellung in Fig. 2c als erneut reflektierte Wellen 26a, 26b in Vorwärtsrichtung 19, 19' in Richtung Last. Die erneut reflektierten Wellen 26a, 26b werden vom Leistungskoppler 11 zu einer weiteren in Vorwärtsrichtung 19"' laufenden Gesamtwelle 27 zusammengeführt, welche aufgrund des mit Linie 22 angedeuteten Phasenversatzes (die Welle 26b eilt der Welle 26a voraus) zwischen den beiden erneut reflektierten Wellen 26a, 26b nicht am ersten Tor 12, sondern am zweiten Tor 13 des Leistungskopplers 11 ausgegeben und in das absorbierende Bauteil 16 abgeleitet wird.

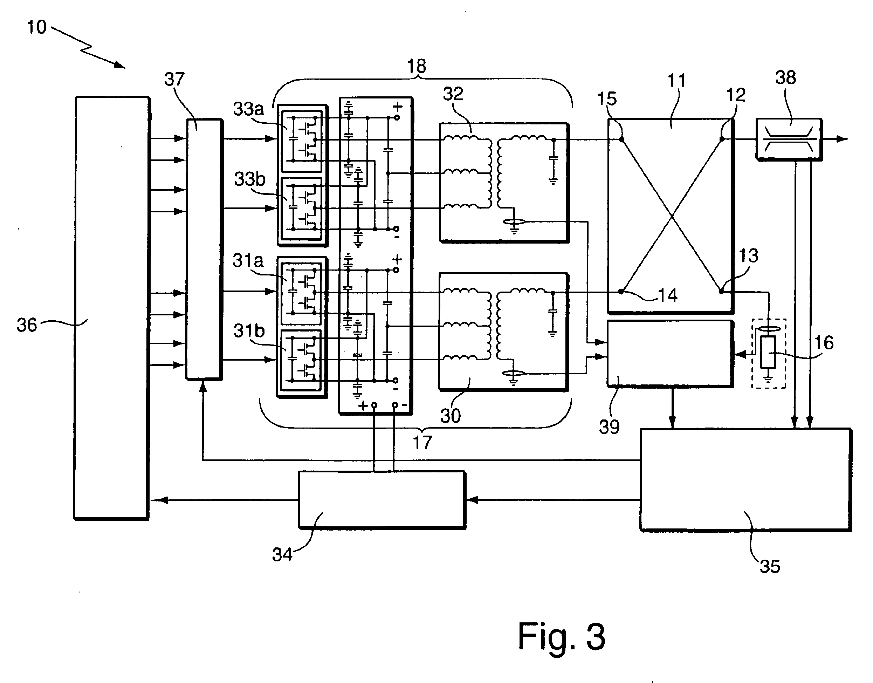

**Fig. 3** zeigt in detaillierterer Weise die Schaltungsstruktur der Plasmaleistungsversorgungseinrichtung 10. Die an das dritte Tor 14 und das vierte Tor 15 des Leistungskopplers 11 angeschlossenen Leistungsversorgungsmodule 17, 18 weisen ein erstes Ausgangsnetzwerk 30 und erste Inverter 31a, 31b sowie ein zweites Ausgangsnetzwerk 32 und zweite Inverter 33a, 33b auf. Die Inverter 31a, 31b, 33a, 33b der Leistungsversorgungsmodule 17, 18 sind an eine DC-Stromversorgung 34 angeschlossen und werden über eine Steuerung 35 und einen mit einem Gatespannungserzeuger 36 verbundenen Signalübertrager 37 individuell angesteuert. Am ersten Tor 12 des Leistungskopplers 11 ist eine als Richtkoppler ausgebildete Messeinrichtung 38 für die an die Last übergebene Ausgangsleistung und die von der Last reflektierte Leistung angeordnet. Die von der Messeinrichtung 38 ermittelten Messwerte werden an die Steuerung 35 übergeben und dort mit einem Referenzwert verglichen. In Abhängigkeit des Vergleichsergebnisses oder in Abhängigkeit von der bestimmten Zeit werden die Inverter 31a, 31b, 33a, 33b bzw. deren schaltenden Elemente so angesteuert, dass sie entweder eine hohe HF-Leistung erzeugen oder dass sie dauernd oder einen überwiegenden Zeitanteil der HF-Periode im ausgeschalteten Zustand verbleiben. An die Steuerung 35 werden weiter die von einer Strommesseinrichtung 39 an den Ausgangsnetzwerken 30, 32 und/oder am absorbierenden Bauteil 16 gemessenen Strommesswerte übergeben.

Zumindest ein Inverter 31a, 31b, 33a, 33b in einer Plasmaleistungsversorgungseinrichtung 10 wird so angesteuert, dass er entweder in einer ersten Betriebsart eine erste, insbesondere hohe HF-Ausgangsleistung an eine Last liefert oder dass er in einer zweiten Betriebsart dauernd oder den überwiegenden Zeitanteil der HF-Periode im passiven, d. h., nichtleitenden Zustand ist und damit keine oder eine geringe HF-Ausgangsleistung an die Last liefert. Die Ansteuerung des zumindest einen Inverters 31a, 31b, 33a, 33b erfolgt in Abhängigkeit der von der Last reflektierten Leistung 23 bzw. einer mit dieser in Beziehung stehenden Größe, welche messtechnisch erfasst und mit zumindest einem Referenzwert verglichen wird. In Abhängigkeit des Vergleichsergebnisses, insbesondere bei Überschreiten eines ersten Referenzwertes, wird der zumindest eine Inverter 31a, 31b, 33a, 33b in der zweiten Betriebsart angesteuert und die von der Last reflektierte Leistung 23, 27 in ein absorbierendes Bauteil 16 abgeleitet wird. In Abhängigkeit eines weiteren Vergleichsergebnisses, insbesondere bei Unterschreiten eines zweiten Referenzwertes, wird der zumindest eine Inverter 31a, 31b, 33a, 33b wieder in der ersten Betriebsart so angesteuert, dass er eine hohe HF-Leistung abgibt. Alternativ oder in einer Kombination mit dieser Vergleichsmethode können eine oder beide der Umschaltungen, in die erste Betriebsart mit hoher HF-Leistung bzw. in die zweite Betriebsart mit niedriger oder keiner HF-Leistung, nach Ablauf zumindest einer bestimmten Zeit, die vorzugsweise der Wellenlaufzeit vom Inverter 31a, 31b, 33a, 33b zur Last und zurück entspricht, erfolgen.

Ein 90°-Hybrid bzw. Hybridkoppler 11 wird so eingesetzt, dass er die HF-Wellenzüge von zwei an seinen Eingängen angeschalteten Leistungsversorgungsmodulen 17, 18 mit Invertern 31a, 31b, 33a, 33b kombiniert und als ein Wellenzug zur Last liefert. Während der von der nicht korrekt angepassten Last reflektierte Anteil des Wellenzuges zurückkommt, befinden sich die Inverter 31a, 31b, 33a, 33b in der zweiten Betriebsart und reflektieren ihrerseits diesen vom Hybridkoppler 11 aufgeteilten Wellenzug. Bei der abermaliger Kombination dieses doppelt reflektieren Wellenzuges sind die Phasenverhältnisse so, dass er zu einem Hybridtor 12 mit Abschlusswiderstand 16 geleitet wird.

## Patentansprüche

1. Verfahren zur Ansteuerung zumindest eines Inverters (31a, 31b, 33a, 33b) in einer Plasmaleistungsversorgungseinrichtung (10), der zumindest ein schaltendes Element aufweist,
wobei der zumindest eine Inverter (31a, 31b, 33a, 33b) in einer ersten Betriebsart derart angesteuert wird, dass er eine erste Ausgangsleistung an eine an die Plasmaleistungsversorgungseinrichtung (10) angeschlossene Last liefert, und in einer zweiten Betriebsart derart angesteuert wird, dass er keine oder eine geringere Ausgangsleistung an die angeschlossene Last liefert, wobei
a) die von der Last reflektierte Leistung (23) oder eine damit in Beziehung stehende Größe messtechnisch erfasst und mit zumindest einem Referenzwert verglichen wird und das Umschalten zwischen erster und zweiter Betriebsart in Abhängigkeit des zumindest einen Vergleichsergebnisses erfolgt, und/oder
b) mit dem Beginn der Ansteuerung in einer Betriebsart eine Zeitmessung gestartet wird und das Umschalten in die andere Betriebsart nach Ablauf zumindest einer bestimmten Zeit erfolgt.

2. Verfahren nach Anspruch 1, **dadurch gekennzeichnet, dass** der zumindest eine Inverter (31a, 31b, 33a, 33b) bei Erreichen eines ersten Referenzwertes von der ersten Betriebsart in die zweite Betriebsart umgeschaltet wird.

3. Verfahren nach Anspruch 1 oder 2, **dadurch gekennzeichnet, dass** der zumindest eine Inverter (31a, 31b, 33a, 33b) bei Erreichen eines zweiten Referenzwertes von der zweiten Betriebsart in die erste Betriebsart umgeschaltet wird.

4. Verfahren nach Anspruch 1 oder 3, **dadurch gekennzeichnet, dass** der zumindest eine Inverter (31a, 31b, 33a, 33b) nach Ablauf einer ersten bestimmten Zeit von der ersten Betriebsart in die zweite Betriebsart umgeschaltet wird.

5. Verfahren nach Anspruch 1, 2 oder 4, **dadurch gekennzeichnet, dass** der zumindest eine Inverter (31a, 31b, 33a, 33b) nach Ablauf einer zweiten bestimmten Zeit von der zweiten Betriebsart in die erste Betriebsart umgeschaltet wird.

6. Verfahren nach einem der vorhergehenden Ansprüche, **dadurch gekennzeichnet, dass** zumindest eine bestimmte Zeit in die Plasmaleistungsversorgungseinrichtung (10) eingegeben wird.

7. Verfahren nach einem der vorhergehenden Ansprüche, **dadurch gekennzeichnet, dass** zumindest eine bestimmte Zeit der Wellenlaufzeit vom Inverter (31a, 31b, 33a, 33b) zur Last und zurück entspricht.

8. Verfahren nach einem der vorhergehenden Ansprüche, **dadurch gekennzeichnet, dass** in der zweiten Betriebsart die von der Last reflektierte Leistung (23, 27) in ein absorbierendes Bauteil (16) abgeleitet wird.

9. Verfahren nach einem der Ansprüche 1 bis 7, **dadurch gekennzeichnet, dass** in der zweiten Betriebsart die von der Last reflektierte Leistung (23) gleichgerichtet und in eine DC-Stromversorgung (34) für den zumindest einen Inverter (31a, 31b, 33a, 33b) rückgeführt wird.

10. Plasmaleistungsversorgungseinrichtung (10) zur Erzeugung einer Ausgangsleistung > 500 W bei einer im Wesentlichen konstanten Grundfrequenz > 3 MHz und zur Leistungsversorgung eines Plasmaprozesses, an welchen die erzeugte Ausgangsleistung (21) geliefert und von welchem reflektierte Leistung (23) zumindest bei Fehlanpassung an die Plasmaleistungsversorgungseinrichtung (10) zurückgeleitet wird,
die Plasmaleistungsversorgungseinrichtung (10) zumindest einen Inverter (31a, 31b, 33a, 33b) mit zumindest einem schaltenden Element und eine Steuerung (35) zur Ansteuerung des zumindest einen Inverters (31a, 31b, 33a, 33b) aufweist und **dadurch gekennzeichnet dass** die Steuerung (35) in Abhängigkeit
a) des von einer Messeinrichtung (38) zur Messung einer mit der von dem Plasmaprozess reflektierten Leistung in Beziehung stehenden Größe und zum Vergleich der gemessenen Größe mit zumindest einem Referenzwert ermittelten Vergleichsergebnisses und/oder
b) zumindest einer bestimmten Zeit, die in einem Speicher zur
Speicherung zumindest der bestimmten Zeit gespeichert ist,
den zumindest einen Inverter (31a, 31b, 33a, 33b) in einer ersten Betriebsart zur Lieferung einer ersten Ausgangsleistung oder in einer zweiten Betriebsart zur Lieferung einer geringeren oder keiner Ausgangsleistung ansteuert.

11. Plasmaleistungsversorgungseinrichtung nach Anspruch 10, **dadurch gekennzeichnet, dass** der zumindest eine Inverter (31a, 31b, 33a, 33b) ein Klasse-D-Verstärker ist.

12. Plasmaleistungsversorgungseinrichtung nach einem der Ansprüche 10 oder 11, **dadurch gekennzeichnet, dass** der zumindest eine Inverter (31a, 31b, 33a, 33b) ein Klasse-E-Verstärker ist.

13. Plasmaleistungsversorgungseinrichtung nach einem der Ansprüche 10 bis 12, **dadurch gekennzeichnet, dass** die Plasmaleistungsversorgungseinrichtung (10) mehrere, bevorzugt zwei, Leistungsversorgungsmodule mit jeweils mindestens einem Inverter (17, 18) aufweist, die über zumindest einen Leistungskoppler (11) zusammengekoppelt sind,
wobei der zumindest eine Leistungskoppler (11) die vorwärts von den Leistungsversorgungsmodulen (17, 18) in Richtung Last laufende Leistung (20a, 20b, 26a, 26b) phasenabhängig auf ein der Leistungsversorgung des Plasmaprozesses zugeordnetes erstes Tor (12) oder ein zweites Tor (13) leitet.

14. Plasmaleistungsversorgungseinrichtung nach einem der Ansprüche 10 bis 13, **dadurch gekennzeichnet, dass** die Plasmaleistungsversorgungseinrichtung (10) zumindest ein absorbierendes Bauteil (16) aufweist, welches von dem Plasmaprozess reflektierte Leistung (23, 27) insbesondere bei der Grundfrequenz zumindest teilweise absorbiert, insbesondere wobei das zumindest eine absorbierende Bauteil (16) an das zweite Tor (13) des zumindest einen Leistungskopplers (11) angeschlossen ist.

15. Plasmaleistungsversorgungseinrichtung nach Anspruch 13 oder 14, **dadurch gekennzeichnet, dass** der zumindest eine Leistungskoppler (11) ein 90°-Hybrid ist.

## Claims

1. A method for controlling at least one inverter (31a, 31b, 33a, 33b) in a plasma power supply device (10), the inverter comprising at least one switching element, wherein the at least one inverter (31a, 31b, 33a, 33b) is controlled in a first operating mode in such a way that it supplies a first output power to a load connected to the plasma power supply device (10), and is controlled in a second operating mode in such a way that it supplies no or a lower output power to the connected load, wherein
a) the power (23) or a variable related thereto reflected by the load is determined metrologically and compared with at least one reference value and the switching between first and second operating modes is effected in dependence on the at least one comparison result, and/or
b) at the start of the control a time measurement is commenced in one operating mode and switching to the other operating mode is effected on expiry of at least one specific time.

2. A method according to claim 1, **characterised in that**, on reaching a first reference value, the at least one inverter (31a, 31b, 33a, 33b) is switched from the first operating mode into the second operating mode.

3. A method according to claim 1 or 2, **characterised in that**, on reaching a second reference value, the at least one inverter (31a, 31b, 33a, 33b) is switched from the second operating mode into the first operating mode.

4. A method according to claim 1 or 3, **characterised in that**, upon expiry of a first specific time, the at least one inverter (31a, 31b, 33a, 33b) is switched from the first operating mode into the second operating mode.

5. A method according to claim 1, 2 or 4, **characterised in that**, upon expiry of a second specific time, the at least one inverter (31a, 31b, 33a, 33b) is switched from the second operating mode into the first operating mode.

6. A method according to any one of the preceding claims, **characterised in that** a least one specific time is entered in the plasma power supply device (10).

7. A method according to any one of the preceding claims, **characterised in that** at least one specific time corresponds to the wave transit time from the inverter (31a, 31b, 33a, 33b) to the load and back.

8. A method according to any one of the preceding claims, **characterised in that** in the second operating mode the power (23, 27) reflected by the load is discharged into an absorbing component (16).

9. A method according to any one of claims 1 to 7, **characterised in that** in the second operating mode the power (23) reflected by the load is rectified and returned to a DC power supply (34) for the at least one inverter (31a, 31b, 33a, 33b).

10. A plasma power supply device (10) for generating an output power > 500 W at a substantially constant fundamental frequency > 3 MHz and for supplying a plasma process with power, the generated output power (21) being supplied to said process and reflected power (23) being returned from said process to the plasma power supply device (10) at least in the event of mismatching,
the plasma power supply device (10) comprising at least one inverter (31a, 31b, 33a, 33b) having at least one switching element, and a control means (35) for controlling the at least one inverter (31a, 31b, 33a, 33b), and **characterised in that**, in dependence on
a) the comparison result determined by a measuring device (38) for measuring a variable related to the power reflected by the plasma process and for comparing the measured variable with at least one reference value, and/or
b) at least one specific time that is stored in a memory for storing at least the
specific time,
the control means (35) controls the at least one inverter (31a, 31b, 33a, 33b) in a first operating mode to supply a first output power or in a second operating mode to supply a lower or no output power.

11. A plasma power supply device according to claim 10, **characterised in that** the at least one inverter (31a, 31b, 33a, 33b) is a class D amplifier.

12. A plasma power supply device according to one of claims 10 and 11, **characterised in that** the at least one inverter (31a, 31b, 33a, 33b) is a class E amplifier.

13. A plasma power supply device according to any one of claims 10 to 12, **characterised in that** the plasma power supply device (10) comprises a plurality of, preferably two, power supply modules each having at least one inverter (17, 18), which are coupled together by at least one power coupler (11),
wherein the power (20a, 20b, 26a, 26b) running in the forward direction from the power supply modules (17, 18) towards the load is conducted by the at least one power coupler (11) in dependence on phase to a first port (12) associated with the power supply of the plasma process or to a second port (13).

14. A plasma power supply device according to any one of claims 10 to 13, **characterised in that** the plasma power supply device (10) comprises at least one absorbing component (16), which at least partially absorbs power (23, 27) reflected by the plasma process, in particular at the fundamental frequency, in particular wherein the at least one absorbing component (16) is connected to the second port (13) of the at least one power coupler (11).

15. A plasma power supply device according to claim 13 or 14, **characterised in that** the at least one power coupler (11) is a 90°-hybrid.

## Revendications

1. Procédé de commande d'au moins un onduleur (31a, 31b, 33a, 33b) dans un dispositif d'alimentation en puissance de plasma (10), lequel présente au moins un élément de commutation,
ledit au moins un onduleur (31a, 31b, 33a, 33b) étant, dans un premier mode de fonctionnement, commandé de façon à délivrer une première puissance de sortie à une charge connectée au dispositif d'alimentation en puissance de plasma (10) et, dans un deuxième mode de fonctionnement, commandé de façon à ne délivrer aucune puissance de sortie ou à délivrer une plus faible puissance de sortie à la charge connectée, et
a) la puissance réfléchie par la charge (23) ou une grandeur en rapport avec celle-ci est détectée par mesure et comparée avec au moins une valeur de référence et la commutation entre premier et deuxième mode de fonctionnement a lieu en fonction du résultat au nombre d'au moins un de la comparaison, et/ou
b) une mesure de temps est démarrée avec le début de la commande dans un mode de fonctionnement et la commutation dans l'autre mode de fonctionnement a lieu après expiration d'au moins un temps déterminé.

2. Procédé selon la revendication 1, **caractérisé en ce que** ledit au moins un onduleur (31a, 31b, 33a, 33b) est commuté du premier mode de fonctionnement dans le deuxième mode de fonctionnement quand une première valeur de référence est atteinte.

3. Procédé selon la revendication 1 ou 2, **caractérisé en ce que** ledit au moins un onduleur (31a, 31b, 33a, 33b) est commuté du deuxième mode de fonctionnement dans le premier mode de fonctionnement quand une deuxième valeur de référence est atteinte.

4. Procédé selon la revendication 1 ou 3, **caractérisé en ce que** ledit au moins un onduleur (31a, 31b, 33a, 33b) est commuté du premier mode de fonctionnement dans le deuxième mode de fonctionnement après expiration d'un premier temps défini.

5. Procédé selon la revendication 1, 2 ou 4, **caractérisé en ce que** ledit au moins un onduleur (31a, 31b, 33a, 33b) est commuté du deuxième mode de fonctionnement dans le premier mode de fonctionnement après expiration d'un deuxième temps défini.

6. Procédé selon une des revendications précédentes, **caractérisé en ce qu'**au moins un temps défini est entré dans le dispositif d'alimentation en puissance de plasma (10).

7. Procédé selon une des revendications précédentes, **caractérisé en ce que** qu'au moins un temps défini correspond au temps de parcours des ondes de l'onduleur (31a, 31b, 33a, 33b) vers la charge et retour.

8. Procédé selon une des revendications précédentes, **caractérisé en ce que** dans le deuxième mode de fonctionnement, la puissance (23, 27) réfléchie par la charge est dérivée dans un composant absorbant (16).

9. Procédé selon une des revendications 1 à 7, **caractérisé en ce que** dans le deuxième mode de fonctionnement, la puissance (23) réfléchie par la charge est redressée et recyclée en une alimentation électrique à courant continu (34) pour ledit au moins un onduleur (31a, 31b, 33a, 33b).

10. Dispositif d'alimentation en puissance de plasma (10) destiné à générer une puissance de sortie > 500 W à une fréquence de base sensiblement constante > 3 MHz et à alimenter en puissance un procédé au plasma auquel la puissance de sortie (21) générée est délivrée et dont la puissance réfléchie (23), au moins en cas de désadaptation, est ramenée au dispositif d'alimentation en puissance de plasma (10),
le dispositif d'alimentation en puissance de plasma (10) présente au moins un onduleur (31a, 31b, 33a, 33b) avec au moins un élément de commutation et une commande (35) pour commander ledit au moins un onduleur (31a, 31b, 33a, 33b) et est **caractérisé en ce que** la commande (35) commande ledit au moins un onduleur (31a, 31b, 33a, 33b) dans un premier mode de fonctionnement pour délivrer une première puissance de sortie ou dans un deuxième mode de fonctionnement pour délivrer une première puissance de sortie plus faible ou aucune puissance de sortie en fonction
a) du résultat de la comparaison déterminée par un dispositif de mesure (38) servant à mesurer une grandeur en rapport avec la puissance réfléchie par le procédé au plasma et à comparer la grandeur mesurée avec au moins une valeur de référence et/ou
b) d'au moins un temps défini qui est enregistré dans une mémoire servant à enregistrer au moins le temps défini.

11. Dispositif d'alimentation en puissance de plasma selon la revendication 10, **caractérisé en ce que** ledit au moins onduleur (31a, 31b, 33a, 33b) est un amplificateur de classe D.

12. Dispositif d'alimentation en puissance de plasma selon une des revendications 10 ou 11, **caractérisé en ce que** ledit au moins onduleur (31a, 31b, 33a, 33b) est un amplificateur de classe E.

13. Dispositif d'alimentation en puissance de plasma selon une des revendications 10 à 12, **caractérisé en ce que** le dispositif d'alimentation en puissance de plasma (10) présente plusieurs, de préférence deux, modules d'alimentation en puissance comportant chacun au moins un onduleur (17, 18), qui sont couplés ensemble par au moins un coupleur de puissance (11),
ledit au moins un coupleur de puissance (11) dirigeant la puissance (20a, 20b, 26a, 26b) se déplaçant en avant depuis les modules d'alimentation en puissance (17, 18) en direction de la charge, en fonction de la phase vers une première porte (12) ou une deuxième porte (13) associée à l'alimentation en puissance du procédé au plasma.

14. Dispositif d'alimentation en puissance de plasma selon une des revendications 10 à 13, **caractérisé en ce que** le dispositif d'alimentation en puissance de plasma (10) présente au moins un composant absorbant (16) qui absorbe, en particulier à la fréquence fondamentale, au moins partiellement la puissance (23, 27) réfléchie par le procédé au plasma, en particulier ledit au moins un composant absorbant (16) étant connecté à la deuxième porte (13) dudit au moins un coupleur de puissance (11).

15. Dispositif d'alimentation en puissance de plasma selon la revendication 13 ou 14, **caractérisé en ce que** ledit au moins un coupleur de puissance (11) est un hybride à 90°.
